Europäisches Patentamt

European Patent Office

Office européen des brevets

(19)

(11) Veröffentlichungsnummer: **0 008 359**
**B1**

(12)

# EUROPÄISCHE PATENTSCHRIFT

(45) Veröffentlichungstag der Patentschrift:
28.07.82

(21) Anmeldenummer: 79102450.8

(22) Anmeldetag: 16.07.79

(51) Int. Cl.³: **H 01 L 21/00, H 01 L 21/90,**
**H 01 L 21/308, G 03 F 7/02**

(54) **Verfahren zum Herstellen einer Dünnfilmstruktur.**

(30) Priorität: 21.08.78 US 935286

(43) Veröffentlichungstag der Anmeldung:
05.03.80 Patentblatt 80/5

(45) Bekanntmachung des Hinweises auf die Patenterteilung:
28.07.82 Patentblatt 82/30

(84) Benannte Vertragsstaaten:
**DE FR GB**

(56) Entgegenhaltungen:
**FR-A-2 312 114**
**FR-A-2 340 620**
**FR-A-2 341 944**
**FR-A-2 357 071**
**US-A-3 795 557**
**US-A-3 961 414**

(73) Patentinhaber: **International Business Machines
Corporation, Armonk, N.Y. 10504 (US)**

(72) Erfinder: **Chang, Kenneth, Saddle Ridge Dr. RD 3 Box 93,
Hopewell Junction, New York 12533 (US)**
Erfinder: **Cosman, David Cecil, 13 Plattekill Turnpike,
Newburgh, N.Y. 12550 (US)**
Erfinder: **Gartner, Helmut Matthew, 7F Surrey Lane,
Wappingers Falls, N.Y. 12590 (US)**
Erfinder: **Hoeg Jr., Anthony John, 49 Ninahm Ave,
Wappingers Falls, N.Y. 12590 (US)**

(74) Vertreter: **Oechssler, Dietrich, Dr.rer.nat. Dipl.-Chem.,
Schönaicher Strasse 220, D-7030 Böblingen (DE)**

## Verfahren zum Herstellen einer Dünnfilmstruktur

Die Erfindung betrifft ein Verfahren zum Herstellen einer Dünnfilmstruktur, bei dem auf einem Substrat ganzflächig ein erster Dünnfilm aus einem ersten Material und darauf ganzflächig ein zweiter Dünnfilm aus einem zweiten Material, wobei die Ätzeigenschaften des ersten Materials sich von denen des zweiten unterscheiden, und darüber ganzflächig eine Schicht aus einem strahlungsempfindlichen Lack aufgebracht werden, bei dem dann in der Lackschicht und in dem zweiten Dünnfilm durchgehende Öffnungen gemäss einem gewünschten Muster erzeugt werden und daraufhin unter Verwendung des zweiten Dünnfilms als Maske und unter Bedingungen, bei denen das erste Material entfernt wird, geätzt wird.

Fortschritte in der modernen Halbleitertechnologie haben es gestattet, eine zunehmende Anzahl von Bauelementen und Schaltkreisen auf einem einzigen Halbleiterchip zu erzeugen. Dazu war eine zunehmende Mikrominiaturisierung des Zwischenverbindungs-Metallisierungssystems notwendig, welches die Bauelemente auf einem Chip zu Schaltkreisen verbindet. Eine solche Miniaturisierung hat verminderte Kosten und eine verbesserte Leistung der integrierten Schaltkreise zur Folge. Auf der anderen Seite ist man bei der Herstellung der Schaltkreise mit dem Problem konfrontiert, dass man es mit zunehmend kleineren Bauelementen und mit zunehmend kleineren Abständen zwischen den Bauelementen zu tun hat, was ganz allgemein bei den photolithographischen Techniken und den Ätzverfahren Probleme hervorruft. Diese Probleme treten auch insbesondere bei der Herstellung des Zwischenverbindungs-Metallisierungssystems auf.

Beispielsweise werden auf einem zwischen ungefähr 10 und 26 mm² grossen Siliciumchip tausende von dotierten Bereichen erzeugt. Solche Bereiche bilden Transistoren, Dioden, Widerstände und ähnliche Bauelemente, welche dann untereinander mittels Dünnfilmverdrahtungsmustern, welche sich oben auf dem Chip befinden, verbunden werden, wodurch unterschiedliche Schaltkreise gebildet werden. Ausserdem sorgen die Dünnfilm-Verdrahtungsmuster für die Verbindung zu den Eingabe- und Ausgabeanschlüssen. Dieses Zwischenverbindungs-Dünnfilmsystem oben auf dem Chip ist ausserordentlich komplex und besteht im allgemeinen aus zwei oder drei komplex aufgebauten Leiterzugmustern, welche sich in verschiedenen, übereinander liegenden Ebenen befinden, welche voneinander durch eine oder mehr Schichten aus dielektrischem Material getrennt sind. Im allgemeinen verbindet das Leiterzugmuster in der ersten Ebene, welches sich am nächsten bei der Chip-Oberfläche befindet, die Transistoren, Widerstände, Dioden usw. zu Schaltkreisen und sorgt auch für die Verbindung von Schaltkreis zu Schaltkreis. Üblicherweise vervollständigt das Leiterzugmuster in der zweiten Ebene die Verbindungen zwischen den Schaltkreisen und stellt den Kontakt zu den Eingabe-

und Ausgabeanschlüssen her, welche mit einem Träger, wie z.B. einem Modul, einem Substrat oder einer Schaltkarte verbunden werden können. Alternativ ist es auch möglich, dass eine dritte Metallisierungsebene für die Verbindungen zu den Eingabe- und Ausgabeanschlüssen und zu den Netzgeräten benutzt wird. Vier Metallisierungsebenen könnten in zukünftigen Produkten benötigt werden.

Im Augenblick erfolgt die Bildung solcher Dünnfilmmuster hauptsächlich mittels Ätzens in der Gegenwart von als Maske dienenden ätzresistenten Photolackschichten. Das Verfahren beinhaltet das traditionelle photolithographische Nassätzen sowohl des Dünnfilms als auch der Photolackschichten.

Diese relativ alten und wohlbekannten Techniken sind ausserordentlich erfolgreich gewesen. Mit der fortschreitenden Miniaturisierung der integrierten Schaltungen auf Halbleiterbasis mit dem Ziel, eine grössere Dichte von Bauelementen und kleinere Einheiten von hochintegrierten Schaltungen zu erhalten, strebt jedoch die Halbleitertechnologie schnell einem Punkt zu, wo das Nassätzen ungeeignet wird, um so hochaufgelöste Muster, wie sie die bald erforderlich werdenden Zwischenverbindungs-Matallisierungssysteme darstellen, zu erzeugen. Das Nassätzen von Dünnfilmen kann im Zusammenhang sowohl mit Elektronenstrahl- als auch mit lichtoptischen Bestrahlungssystemen angewandt werden. Jedoch hat es oft eine Kontaminierung des Metalls zur Folge, was insbesondere auf Teilchen in der Ätzlösung zurückzuführen ist. Es muss also die Reinheit des Ätzmittels sehr genau kontrolliert werden. Ausserdem muss aber auch die Zusammensetzung des Ätzmittels und die Dauer des Ätzens sehr genau kontrolliert werden, um ein Unter- bzw. Überätzen des Dünnfilms zu verhindern.

Das Trockenätzen, insbesondere das Plasma- oder reaktive Ionenätzen, ist vor relativ kurzer Zeit als praktische Alternative zu dem Nassätzen erkannt worden. Die Kontaminierung ist dabei ein geringeres Problem und die Ätzvorrichtungen stellen eine ausreichende Prozesssteuerung für die sehr genaue und mustergetreue Herstellung von Dünnfilmmustern sicher.

Eines der Probleme, welches beim Plasmaätzen von Dünnfilmen auftritt, besteht darin, dass die meisten der wohlbekannten und üblicherweise verwendeten licht- und elektronenstrahlempfindlichen Lackmaterialien das Ätzen nicht heil überstehen. Die Lacke neigen dazu, während des Ätzprozesses zu fliessen, was anscheinend auf die Reaktionen des Lackmaterials mit den gasförmigen Ionen und auf die Temperatur des Halbleitersubstrats, welche typischerweise bei 200°C oder mehr liegt, zurückzuführen ist. An sich wäre es wünschenswert, beim Herstellen des Leiterzugmusters so vorzugehen, dass zunächst eine direkte auf dem metallischen Dünnfilm aufgebrachte Photolackschicht derart in einem Plasma geätzt wird, dass das gewünschte Leiterzugmuster in der Photolackschicht definiert wird, dass dann der metallische Dünnfilm unter Verwendung des Musters in der Photolackschicht als Maske und unter Anwendung eines Gases, welches das Metall aber nicht den Photolack angreift, in einem Plasma geätzt wird, und dass schliesslich der restliche Photolack auf konventionelle Art und Weise unter Zurücklassung des gewünschten Musters im Dünnfilm entfernt wird.

Nach unserer Erkenntnis gibt es jedoch keinen praktischen Weg, um bei der Herstellung des Musters im Dünnfilm in dieser Weise vorzugehen. Eine Anzahl von unterschiedlichen Lackmaterialien und von unterschiedlichen reaktiven Gasen sind untersucht worden, jedoch war der Erfolg gering.

Ein Vorschlag, um das erwähnte Problem zu umgehen, ist in dem US-Patent 4 092 442 beschrieben. Die Erfinder fanden, dass eine Polyimidmaske solchen Bedingungen des reaktiven Ionenätzens widerstehen kann, bei denen sich die bekannten Lackmaterialien zersetzen. In dem, in dem US-Patent beschriebenen Verfahren, wird diese Eigenschaft des Polyimids in der Weise benutzt, dass eine Polyimidschicht auf dem metallischen Dünnfilm abgeschieden wird und anschliessend eine Lackschicht aufgebracht wird. Beide Schichten werden selektiv bestrahlt. Anschliessend wird der Lack entwickelt und das Polyimid selektiv geätzt, wobei Teile des darunterliegenden Dünnfilms freigelegt werden. Die freiliegenden Bereiche des Dünnfilms werden dann in einem Gasplasma geätzt. Bei dem Plasmaätzen wird auch die noch vorhandene Lackschicht entfernt. Die Polyimidschicht schützt die nicht freigelegten Bereiche des Dünnfilms vor dem Angriff des Gasplasmas. Die Polyimid-Maske wird nach Gebrauch entfernt. In dem US-Patent 3 994 793 ist die Anwendung von Siliciumdioxid als Maskenmaterial zum Ätzen von Aluminium auf einem Halbleitersubstrat beschrieben. Die umgekehrte Operation, nämlich die Verwendung von Aluminium als Maskenmaterial beim Ätzen von Siliciumdioxid ist in dem US-Patent 3 971 864 beschrieben. Auch bei den beiden zuletzt genannten Verfahren wird das Maskenmaterial nach dem Ätzen wieder entfernt.

Obwohl die in den genannten US-Patentschriften beschriebenen Verfahren erfolgreich angewandt werden können, sind sie relativ kompliziert, da sie zusätzliche Verfahrensschritte erfordern. Dadurch wird das Herstellungsverfahren verteuert und die zusätzlichen Verfahrensschritte sind potentielle, die Ausbeute erniedrigende Faktoren.

Es ist die Aufgabe der Erfindung, ein relativ einfaches Verfahren zum Herstellen einer Dünnfilm-Struktur anzugeben, mit dem Muster sehr hoher Auflösung in die Struktur eingebaut werden können und bei dem in der Struktur ohnehin erforderliche Schichten als Ätzmasken verwendet werden.

Diese Aufgabe wird mit einem Verfahren der eingangs genannten Art mit den Merkmalen des kennzeichnenden Teils des Anspruches 1 gelöst.

Dadurch, dass die als Masken dienenden Dünnfilme in der Struktur verbleiben, ist das erfindungsgemässe Verfahren einfacher als die bekannten und damit ist auch die Wahrscheinlichkeit, gute Ausbeuten zu erzielen, höher als bei den bekannten Verfahren.

Es ist vorteilhaft, wenn das Ätzen unter Verwendung des darüberliegenden Dünnfilms als Maske mittels reaktiven Ionenätzens durchgeführt wird. Da es sichergestellt ist, dass sich das Maskenmaterial in seinen Ätzeigenschaften stark vom zu ätzenden Material unterscheidet, ist dabei nicht zu befürchten, dass die Maske nach einer bestimmten Ätzzeit ihre Funktion nicht mehr erfüllen kann, vielmehr lässt sich das in der Maske ausgebildete Muster sehr genau in das zu ätzende Material übertragen. Die genaue Musterdefinition in der Ätzmaske ist dabei kein Problem, da zur Musterdefinition die empfindlichsten und eine hohe Mustertreue bei der Übertragung gewährleistenden strahlungsempfindlichen Lacke benutzt werden können, wobei diese Lacke nicht auch noch die zusätzliche Eigenschaft aufweisen müssen, beim reaktiven Ionenätzen gegenüber einem Ätzangriff resistent zu sein.

Es ist vorteilhaft, wenn der Dünnfilm, auf welchen die Lackschicht aufgebracht wird, dünner als der unmittelbar darunter befindliche Dünnfilm gemacht wird. Der Dünnfilm unter der Lackschicht dient später als Ätzmaske, und die genaue Musterdefinition im zu ätzenden Dünnfilm ist um so leichter, je dünner der als Maske dienende Dünnfilm gemacht wird.

Das erfindungsgemässe Verfahren ist sehr vielseitig. Es kann dazu benutzt werden, Muster hoher Auflösung in isolierenden und in leitfähigen Materialien zu erzeugen.

Das erfindungsgemässe Verfahren kann vorteilhaft bei der Herstellung von Metallisierungsstrukturen mit Leiterzugmustern in mindestens zwei Ebenen, welche leitend miteinander verbunden und im übrigen durch ein Isoliermaterial getrennt sind und gegebenenfalls mittels einer Passivierungsschicht vor äusseren Einflüssen geschützt sind, eingesetzt werden.

Weitere vorteilhafte Ausgestaltungen des erfindungsgemässen Verfahrens ergeben sich aus den Unteransprüchen.

Die Erfindung wird anhand von durch Zeichnungen erläuterten Ausführungsbeispielen beschrieben.

Es zeigen:

Fig. 1A bis 1L in schematischen Querschnittsdarstellungen eine Struktur in verschiedenen Stadien ihrer Herstellung unter Anwendung einer bevorzugten Ausführungsform des erfindungsgemässen Verfahrens und ausserdem ein Flussdiagramm, in welchem jeder Verfahrensschritt aufgeführt ist und

Fig. 2 und 3 schematische Querschnittsdarstellungen der Struktur in späteren Stadien der Herstellung.

Anhand der Figuren wird nun die bevorzugte Ausführungsform des erfindungsgemässen Verfahrens beschrieben. Die Struktur in diesen Figuren ist ein Ausschnitt aus einem Chip mit integrierten Schaltungen, welches gemäss irgend eines der konventionellen Verfahren zur Herstellung integrierter Schaltungen erzeugt worden sein kann. In der bevorzugten Ausführungsform besteht das Substrat typischerweise aus einem Isolator wie z.B. aus Siliciumdioxid, Siliciumnitrid oder aus einer aus Siliciumdioxid und Siliciumnitrid bestehenden Schichtstruktur. Bei den üblichen Verfahren ist das Substrat auf einem nichtgezeigten Halbleiterkörper aus Silicium aufgebracht. Öffnungen, welche nicht gezeigt sind, sind vorhanden, um Bereiche in einer darunterliegenden Halbleiterschicht mit dem Leiterzugmuster, welches auf der Oberfläche des Substrats 2 ausgebildet ist, zu verbinden. Aus Gründen der Klarheit und der Kürze ist in den Figuren, welche die bevorzugte Ausführungsform des erfindungsgemässen Verfahrens illustrieren sollen, die Darstellung des Halbleiterkörpers aus Silicium und die Kontaktöffnungen in dem die Isolierschicht bildenden Substrat 2 weggelassen. Obwohl bei unserer bevorzugten Ausführungsform insbesondere die Bildung eines ersten dünnen Filmmusters beabsichtigt ist, welches mit Bereichen innerhalb eines Halbleiterkörpers verbunden ist und auf welchem ein zweites und drittes Metallisierungsniveau aufgebracht ist, kann unser Verfahren auch mit dem zweiten und/oder dritten Metallisierungsniveau beginnen. Darüber hinaus ist unser Verfahren nicht auf die Herstellung von Mustern auf Halbleitersubstraten beschränkt, sondern ist auch anwendbar bei der Herstellung von Mustern auf anderen Substrattypen.

Auf dem Substrat 2 ist ein erster Dünnfilm 4 aufgebracht, in welchem ein Muster erzeugt werden soll. In unserer bevorzugten Ausführungsform kann der erste Dünnfilm 4 aus irgendeinem Metall oder leitfähigen Material, welches üblicherweise für die Herstellung von Metallisierungsmustern in integrierten Schaltungen benutzt wird, d.h. beispielsweise aus Aluminium, Aluminium-Kupfer-Siliciumlegierungen, dotiertem Silicium, Platin, Palladium, Chrom oder Molybdän, bestehen. Darüber hinaus sind Tantal oder Titan-Wolfram-Legierungen geeignet. Darüber hinaus kann der erste Dünnfilm 4 aus einer zusammengesetzten, aus mehr als einem Metall bestehenden Schicht bestehen. Der dünne Film wird konventionell mittels Aufdampfens oder Kathodenzerstäubens aufgebracht und hat typischerweise eine Dicke in der Grössenordnung von 1 µm. Er wird im folgenden als erster Metallfilm bezeichnet.

Als nächstes wird als zweiter Dünnfilm ein dünner erster Glasfilm 6 auf dem ersten Metallfilm 4 aufgebracht. Der erste Glasfilm 6 soll bei dem nachfolgenden Ätzen des ersten Metallfilms 4 als Maske dienen. Deshalb kann der erste Glasfilm 6 sehr dünn gemacht werden. Bevorzugt hat der erste Glasfilm 6 eine Dicke von ungefähr 0,3 µm, jedoch ist seine Dicke nicht kritisch. Das Glas kann mittels Kathodenzerstäubens oder mittels chemischen Niederschlagens aus der Dampfphase aufgebracht werden.

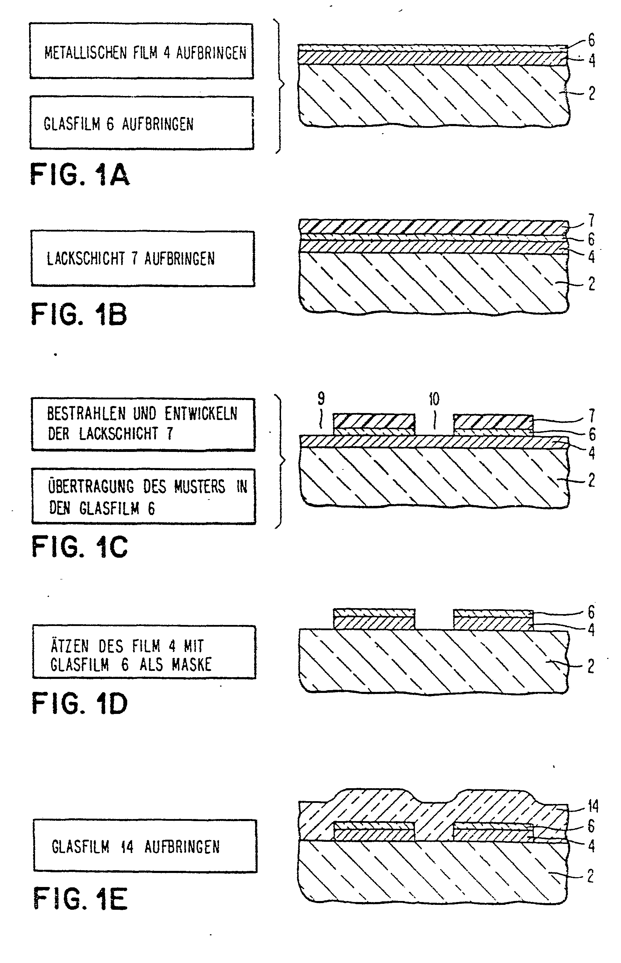

Wie in der Fig. 1B gezeigt wird, wird als nächstes eine Photolackschicht 7 auf dem ersten Glasfilm 6 aufgebracht. Der Photolack kann irgendein konventioneller licht- oder elektronenstrahlempfindlicher Lack sein. Beispielsweise wird der Lack in einer Dicke zwischen ungefähr 0,5 und 1,5 µm aufgebracht. Er wird dann in der üblichen Art und Weise erhitzt. Die Dicke des Lacks kann sehr gering sein, was ein Vorteil beim Ausrichten von Mustern in einem Elektronenstrahl-Bestrahlungssystem ist, da der erste Glasfilm 6 sehr dünn sein kann.

Zusätzlich zu PMMA (Polymethylmethacrylat), welches ein elektronenstrahlenempfindlicher Positivlack ist, kann eine grosse Anzahl von elektronenstrahlenempfindlichen Lacken benutzt werden. Die Methoden, um diese Lacke aufzubringen, entweder mit einem Elektronenstrahl oder mit UV-Licht zu bestrahlen und dann zu entwickeln, sind den Fachleuten auf diesem Gebiet wohl bekannt.

Fortfahrend in dem bevorzugten Prozess wird der Lack zur Bildung eines gewünschten Musters selektiv bestrahlt. Nach der Bestrahlung wird die Lackschicht mit einer verdünnten organischen oder anorganischen basischen Lösung entwickelt. Dabei werden ausgewählte Bereiche der Lackschicht entsprechend dem gewünschten Muster entfernt. Dabei werden Bereiche des ersten Glasfilms 6 in den in der Lackschicht 7 gebildeten Fenstern freigelegt. Anschliessend wird der erste Glasfilm 6, üblicherweise unter Verwendung von gepufferter Flusssäure, geätzt, wobei die Lackschicht 7 als Maske dient. Nach Abschluss dieses Schritts sind – wie die Fig. 1C zeigt – die Fenster 9 und 10 bis zum ersten Metallfilm 4 geöffnet. Der Rest der Lackschicht 7 kann dann entweder nasschemisch oder mittels Veraschens entfernt werden.

Die Struktur wird dann einem Trocken-Plasmaätz-(reaktives Ionenätz-)Verfahren unterworfen, wobei ein reaktives Gas, welches die freiliegenden Bereiche des ersten Metallfilms 4 ätzt und als Maske der erste Glasfilm 6 benutzt werden. Wenn an dieser Stelle des Verfahrens der Lackfilm 7 noch nicht entfernt worden ist, werden bei diesem Ätzprozess die Reste der Lackschicht 7 auch weggeätzt. Das reaktive Gas besteht bevorzugt aus Tetrachlorkohlenstoff ($CCl_4$), welches übliche Metallfilme, wie diejenigen aus den aufgezählten Metallen, angreift. Zu den anderen Gasen, welche auch benutzt werden können, gehören HCl, $Cl_2$, HBr, $Br_2$ und Trichloräthylen. Freonmaterialien, wie z.B. $FCCl_3$, $F_2CCl_2$, FCl, FOCl usw. sind auch wirkungsvoll.

Bei dem Plasmaätzschritt wird in dem ersten Metallfilm 4 ein Muster der gewünschten Art, wie es in der Fig. 1C gezeigt ist, erzeugt.

Der erste Glasfilm 6, der beim Ätzen des ersten Metallfilms 4 als Maske gedient hat, bleibt auf dem Metall, da keine Notwendigkeit besteht, sie zu entfernen. Sie bleibt als eine stabile Passivierungsschicht, welche das Muster aus dem darunterliegenden ersten Metallfilm 4 schützt.

In der Fig. 1E ist die Struktur gezeigt, nach dem ein zweiter Glasfilm 14 ganzflächig auf ihr aufgebracht worden ist. Der zweite Glasfilm 14 dient als Isolierung zwischen der gezeigten ersten Metallisierungsebene und einer zweiten Metallisierungsebene, welche in einem späteren Verfahrensabschnitt erzeugt werden soll. Die Dicke des zweiten Glasfilms 14 liegt typischerweise bei ungefähr 1 bis 2 µm oder mehr. Mit dem Begriff «Glas» werden in dieser Anmeldung Materialien, wie z.B. Siliciumdioxid, Siliciumnitrid oder andere Verbindungen, welche üblicherweise als Material für Isolier- oder Passivierungsschichten benutzt werden, bezeichnet.

Einige der Vorteile des erfindungsgemässen Verfahrens gegenüber bekannten Verfahren lassen sich anhand der bis jetzt abgehandelten Figuren verdeutlichen. In erster Linie wird der erste Glasfilm 6 selbst als stabiles Maskenmaterial verwendet und nicht die Lackschicht 7. Dies ist insbesondere dann wichtig, wenn der erste Metallfilm in der reaktiven Ionenätzkammer geätzt wird, weil, wie schon oben angemerkt wurde, die Lackmaske während des reaktiven Ionenätzens errodieren würde. Indem während des Ätzens des ersten Metallfilms 4 die Lackschicht nicht als Maske verwendet wird, wird dieses Problem auf ein Minimum reduziert, und zwar unabhängig davon, ob die Lackschicht vor dem Ätzen in der reaktiven Ionenätzkammer entfernt wird oder nicht. Ein anderer Vorteil unseres Prozesses liegt daran, dass standardisierte, wohlbekannte Materialien und Methoden bei dem Fabrikationsprozess eingesetzt werden. Jedes der eingesetzten Materialien gehört zum wohlbekannten Stand der Technik.

Nachdem der zweite Glasfilm 14 mittels konventioneller Techniken wie z.B. mittels Kathodenzerstäubens oder chemischen Niederschlagens aus der Gasphase, abgeschieden worden ist, wird ein zweiter leitfähiger Film 16 auf dem zweiten Glasfilm 14 abgeschieden. Dieser Film kann ebenso wie der erste Metallfilm 4 aus irgendeinem Metall bestehen, welches üblicherweise zur Herstellung der Metallisierung in einem integrierten Schaltkreis verwendet wird. Bevorzugt besteht der zweite Metallfilm 16 aus Aluminium. Der zweite Metallfilm 16 wird sowohl als Maske bei der Bildung der Durchführungslöcher durch den zweiten und ersten Glasfilm 14 und 6 dienen als auch als Teil des leitfähigen Musters der zweiten Ebene auf dem Chip verwendet werden. Da der zweite Metallfilm 16 als Maske für das nachfolgende Ätzen der darunterliegenden Glasschichten verwendet werden soll, kann er sehr dünn gemacht werden und bevorzugt ungefähr 0,3 µm dick sein. Allerdings ist seine Dicke wie auch die Dicke des ersten Glasfilms 6 nicht kritisch. Das Metall kann mittels üblicher Kathodenzerstäubungs- oder Aufdampftechniken aufgebracht werden.

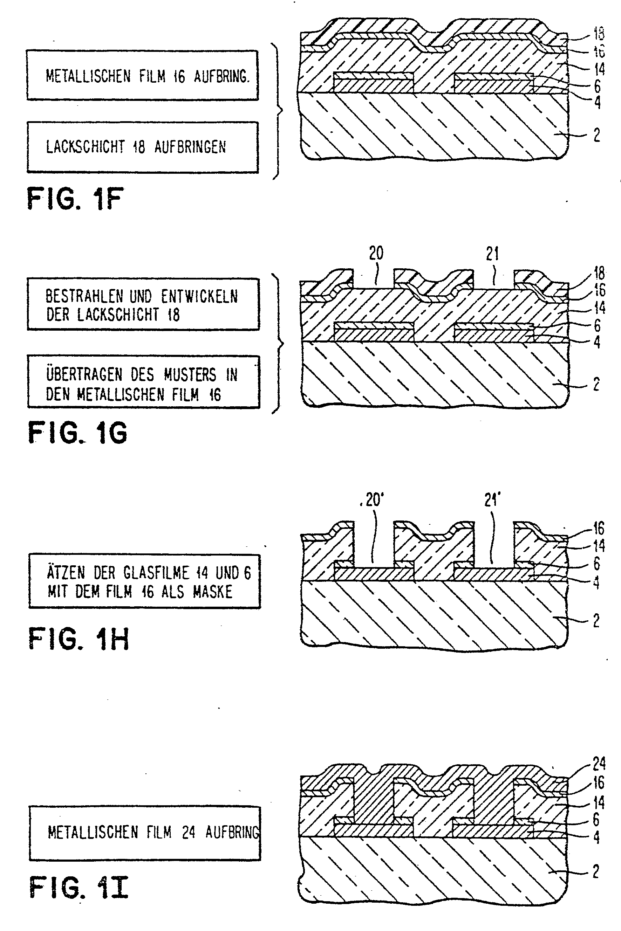

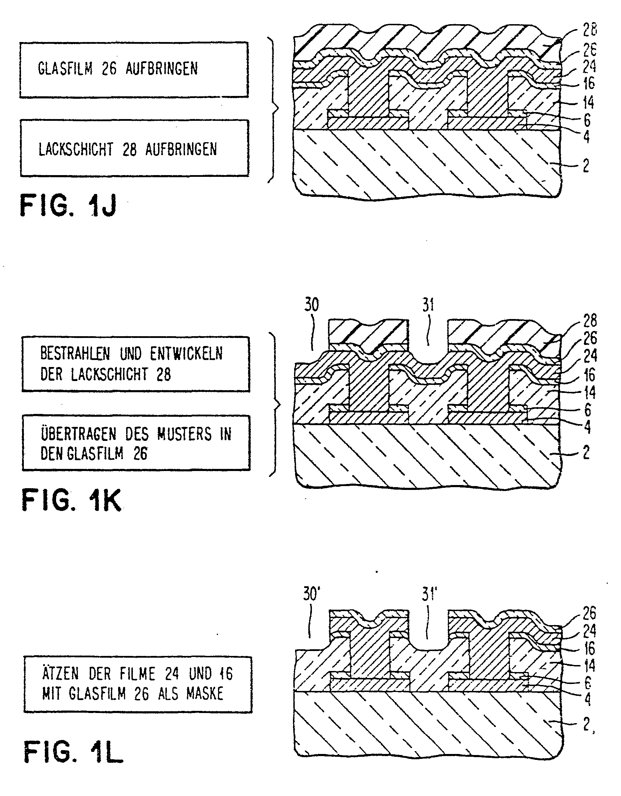

Auf dem zweiten Metallfilm 16 wird eine Lackschicht 18 aufgebracht. Der Lack kann vom selben Typ und von derselben Dicke sein wie die Lackschicht 7, welche anhand der Fig. 1B und 1C weiter oben besprochen worden ist. Die Struktur in diesem Stadium der Herstellung ist in der Fig. 1F gezeigt.

Der Lack wird selektiv bestrahlt, um ein gewünschtes Muster für das Ätzen der Durchführungslöcher durch den zweiten und ersten Glasfilm 14 und 6 bis zum ersten Metallfilm 4 der ersten Ebene zu erzeugen. Nach Abschluss der Bestrahlung wird die Lackschicht 18 entwickelt, wobei ausgewählte Bereiche des Lacks entfernt werden. Dabei werden Bereiche des zweiten Metallfilms 16 in den Fenstern in der Lackschicht 18 freigelegt. Der zweite Metallfilm 16 wird dann unter Verwendung eines geeigneten Ätzmittels, welches die Lackschicht 18 oder den zweiten Glasfilm 14 nicht wesentlich angreift, geätzt. Besteht beispielsweise der zweite Metallfilm 16 aus Aluminium oder Aluminium-Kupfer, so kann eine Mischung aus Phosphor- und Salpetersäure als Ätzmittel dienen. Als Ergebnis dieses Ätzschritts werden, wie die Fig. 1G zeigt, Fenster 20 und 21, welche durch die Lackschicht 18 und den zweiten Metallfilm 16 hindurchgehen, erhalten. In den Fenstern 20 und 21 liegen Bereiche des zweiten Glasfilms 14 frei. Die Lackschicht 18 kann dann mittels konventioneller Techniken geätzt werden. Die Durchführungslöcher 20' und 21' können in das Quarz hinein mittels reaktiven Ionenätzens oder mittels nasschemischer Methoden geätzt werden. Wenn die erstere Technik angewandt wird, hat das erfindungsgemässe Verfahren, wie weiter oben diskutiert wurde, den Vorteil, dass keine Lackschicht während des Trockenätzens als Maske verwendet wird. Vielmehr dient das Muster in dem Metallfilm 16 als Maske. Die dann vorliegende Struktur zeigt die Fig. 1H.

Ein dritter leitfähiger Film 24 wird dann ganzflächig auf dem zweiten Metallfilm 16 und in den Durchführungslöchern 20' und 21' abgeschieden. Dabei wird die erste Metallisierungsebene (erste Metallschicht 4) mit der zweiten Metallisierungsebene, d.h. mit dem dritten leitfähigen Film 24, in der bis dahin noch kein Muster erzeugt worden ist, verbunden. Die in diesem Verfahrensstadium vorliegende Struktur zeigt die Fig. 1I.

In der bevorzugten Ausführungsform des erfindungsgemässen Verfahrens kann der dritte leitfähige Film 24 aus irgendeinem der weiter oben aufgezählten Metalle bestehen, welche üblicherweise zur Herstellung der Leiterzüge in integrierten Schaltungen benutzt werden.

Bevorzugt besteht der dritte Metallfilm 24 aus Aluminium. Der dritte Metallfilm 24 wird in üblicher Art und Weise mittels Aufdampfens oder mittels Kathodenzerstäubens aufgebracht und hat typischerweise eine Dicke in der Grössenordnung von 1,5 µm.

In den Fällen, in denen die Wände der Durchführungslöcher 20' und 21' einen Überhang aufweisen, kann es notwendig sein, den dritten Metallfilm 24 mittels Kathodenzerstäubens abzuscheiden, um eine vollständige Kontinuität des dritten Metallfilms 24 innerhalb der Durchführungslöcher sicherzustellen.

Auf dem dritten Metallfilm 24 wird ein dünner dritter Glasfilm 26 abgeschieden. Der dritte Glasfilm 26 soll bei dem nachfolgenden Ätzen des dritten Metallfilms 24 als Maske dienen. Wie schon im Zusammenhang mit dem ersten Glasfilm 6 besprochen worden ist, kann der dritte Glasfilm 26 sehr dünn gemacht werden und bevorzugt ungefähr 0,3 µm dick sein, und kann mittels Kathodenzerstäubens oder mittels Aufdampfens aufgebracht werden.

Auf dem dritten Glasfilm 26 wird dann eine Lackschicht 28 aufgebracht. Diese Lackschicht kann aus irgendeinem licht- oder elektronenstrahlempfindlichen Lack bestehen, wobei dasselbe gilt, wie schon weiter oben im Zusammenhang mit der Lackschicht 7 gesagt worden ist. Die Lackschicht 28 wird in einer Dicke im Bereich zwischen ungefähr 0,5 und 1,5 µm aufgebracht und dann in der üblichen Art und Weise erhitzt. Die dann vorliegende Struktur zeigt die Fig. 1J.

Die Lackschicht 28 wird selektiv zur Bildung eines gewünschten Musters bestrahlt. Nach dem Abschluss des Bestrahlens wird die Lackschicht 28 mit einer verdünnten organischen oder anorganischen basischen Lösung entwickelt. Beim Entwickeln werden ausgewählte Bereiche der Lackschicht entfernt.

In den beim Entwickeln entstehenden Fenstern in der Lackschicht 28 liegen Bereiche des Glasfilms 26 frei. Der dritte Glasfilm 26 wird dann typischerweise mittels gepufferter Flusssäure geätzt, wobei die Lackschicht 28 als Maske dient. Nach Abschluss dieses Ätzschritts sind die Fenster 30 und 31 bis zu dem dritten Metallfilm 24 geöffnet. Die Fig. 1K zeigt die Struktur in diesem Stadium der Herstellung. Der Rest der Lackschicht 28 kann anschliessend entfernt werden.

Die Struktur wird dann einem Trocken-Plasma-Ätzverfahren unter Verwendung eines reaktiven Gases unterworfen, bei dem Fenster 30' und 31' in die freiliegenden Bereiche des dritten und zweiten Metallfilms 24 und 16 geätzt werden. Wenn die Lackschicht 28 in diesem Verfahrensstadium noch nicht entfernt worden ist, bewirkt der Ätzprozess, dass auch die Reste der Lackschicht 28 weggeätzt werden. Das reaktive Gas besteht bevorzugt aus Tetrachlorkohlenstoff oder aus anderen, weiter oben aufgezählten Gasen. Es kann auch ein nasschemisches Ätzverfahren angewandt werden.

Mittels des Plasmaätzens werden in dem ditten und zweiten Metallfilm 24 und 16 das gewünschte, in der Fig. 1L gezeigte Muster erzeugt. Das Muster bildet die zweite Metallisierungsebene, welche über das leitfähige Material in den Fenstern 20' und 21' in dem zweiten Glasfilm 14 mit der ersten Metallisierungsebene verbunden ist.

Der dritte Glasfilm 26, welcher als Maske beim Ätzen des dritten Metallfilms 24 gedient hat, bleibt auf dem Metall liegen. Er dient als stabile Passivierungsschicht für das Muster aus dem darunterliegenden dritten Metallfilm 24.

Die Vorteile des erfindungsgemässen Verfahrens werden auch an diesem Punkt deutlich. Der dritte Glasfilm 26 wird selbst als stabiles Maskierungsmaterial benutzt und nicht die Lackschicht 28. Dies ist besonders dann wichtig, wenn der dritte und zweite Metallfilm 24 und 16 in der reaktiven Ionenätzkammer geätzt wird, weil die Lackmaske während des reaktiven Ionenätzens erodieren wird.

Die Verfahrensschritte zur Bildung einer dritten und einer vierten Metallisierungsebene auf der jetzt vorliegenden Struktur sind im wesentlichen dieselben, welche auch bei der Bildung der zweiten Metallisierungsebene angewandt worden sind.

Deshalb wird die Beschreibung des restlichen Prozesses abgekürzt, um die Angabe von unnötigen Details zu vermeiden.

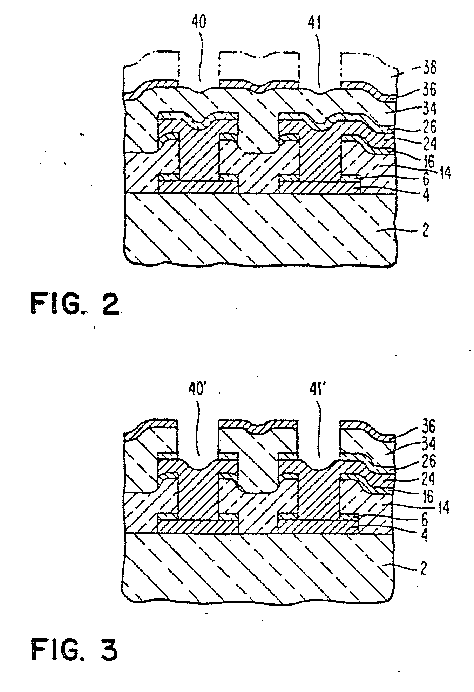

In der Fig. 2 ist ein vierter Glasfilm 34 gezeigt, welcher ganzflächig auf den dritten Glasfilm 26 und in den Zwischenräumen des Musters aus dem dritten Metallfilm 24 abgeschieden ist, und als Isolierung zwischen der gezeigten zweiten Metallisierungsebene und der dritten Metallisierungsebene, welche in einem späteren Verfahrensabschnitt aufgebracht wird, dient. Nachdem der vierte Glasfilm 34 abgeschieden worden ist, wird ein dünner vierter leitfähiger Film 36, welcher beispielsweise aus Aluminium besteht, auf dem vierten Glasfilm 34 abgeschieden. Der vierte Metallfilm 36 dient sowohl als Maske, um Durchführungslöcher durch den vierten und dritten Glasfilm 34 und 26 zu erzeugen als auch als Teil des Musters in der dritten Metallisierungsebene über dem Chip.

Auf dem vierten Metallfilm 36 wird eine Lackschicht 38 aufgebracht. Diese Schicht kann aus einem der oben besprochenen Lackmaterialien bestehen. Der Lack wird selektiv zur Bildung eines gewünschten Musters bestrahlt. Dieses Muster definiert die Durchführungslöcher durch den vierten und dritten Glasfilm 34 und 26 hindurch zu dem dritten Metallfilm 24 in der zweiten Metallisierungsebene. Nach dem Abschluss der Bestrahlung wird der Lackfilm 38 entwickelt, wobei Bereiche des vierten Metallfilms 36 in den Fenstern in der Lackschicht 38 freigelegt werden. Der vierte Metallfilm 36 wird dann geätzt, wobei typischerweise ein Ätzmittel verwendet wird, welches die Lackschicht 38 und den vierten Glasfilm 34 nicht wesentlich angreift. Es entstehen dabei die Fenster 40 und 41, welche durch die Lackschicht 38 und den vierten Metallfilm 36 hindurchgehen und welche Ausschnitte aus dem vierten Glasfilm 34 freilegen. Die dann vorliegende Struktur ist in der Fig. 2 gezeigt. Die Lackschicht 38 kann dann mittels konventioneller Verfahren entfernt werden und anschliessend können Durchführungslöcher 41 und 41' in das Quarz, entweder mittels Trockenätzverfahren oder mittels nasschemischer Ätzverfahren geätzt werden. Wenn die erstere Technik benutzt wird, hat das vorliegende Verfahren den schon oben diskutierten Vorteil, dass keine aus Lack bestehende Maske während des Trockenätzens benutzt wird. Vielmehr wirkt der Metallfilm 36 als Maske. Die dann vorliegende Struktur ist in der Fig. 3 gezeigt.

Eine nichtgezeigte leitfähige Schicht kann dann ganzflächig dem vierten Metallfilm 36 und in den Durchführungslöchern 40' und 41' abgeschieden werden. Diese Schicht dient der Bildung der dritten Metallisierungsebene. Die Verfahrensschritte zur Bildung des Musters in der dritten Metallisierungsebene sind dieselben, welche bereits im Zusammenhang mit der Bildung des Musters in der zweiten Metallisierungsebene besprochen worden sind.

Zusammenfassend kann gesagt werden, dass die Erfindung in einem verbesserten Verfahren zur Bildung von Dünnfilm-Zwischenverbindungssystemen auf Substraten besteht. Bei der bevorzugten Ausführungsform des erfindungsgemässen Verfahrens wird eine Passivierungsschicht aus Glas als stabile Maske zum Ätzen eines Metallisierungsmusters benutzt. Umgekehrt dient das Metallisierungsmuster als stabile Maske, um die Passivierungsschicht aus Glas zur Bildung der Durchführungslöcher zu ätzen. Auf diese Weise ist es möglich, auf Lackmasken beim Ätzen dieser Leiterzugmuster und Durchführungslöcher zu verzichten. Dadurch ist es möglich, diese Ätzprozesse in einer reaktiven Ionenätzkammer durchzuführen. Das erfindungsgemässe Verfahren ist brauchbar, um so viele Metallisierungsebenen, wie gewünscht werden, zu erzeugen.

**Patentansprüche**

1. Verfahren zum Herstellen einer Dünnfilmstruktur, bei dem auf einem Substrat (2) ganzflächig ein erster Dünnfilm (4) aus einem ersten Material und darauf ganzflächig ein zweiter Dünnfilm (6) aus einem zweiten Material, wobei die Ätzeigenschaften des ersten Materials sich von denen des zweiten unterscheiden, und darüber ganzflächig eine Schicht (7) aus einem strahlungsempfindlichen Lack aufgebracht werden, bei dem dann in der Lackschicht (7) und in dem zweiten Dünnfilm (6) durchgehende Öffnungen (9, 10) gemäss einem gewünschten Muster erzeugt werden und daraufhin unter Verwendung des zweiten Dünnfilms (6) als Maske und unter Bedingungen, bei denen das erste Material entfernt wird, geätzt wird, dadurch gekennzeichnet, dass danach auf dem jeweils letztaufgebrachten Dünnfilm und seinen Öffnungen die obengenannten Verfahrensschritte ab dem Aufbringen eines Dünnfilms bis zum Ätzen unter Verwendung des darüberliegenden Dünnfilms als Maske mindestens einmal wiederholt werden, wobei solche Materialien verwendet werden, dass die Ätzeigenschaften des Materials, aus dem der erste bei einer Wiederholung aufgebrachte Dünnfilm (14) besteht, denen des Materials, aus dem der letzte vor dieser Wiederholung aufgebrachte Dünnfilm (6) besteht, gleichen, und wobei die Ätzeigenschaften des Materials, aus dem der zweite, bei einer Wiederholung aufgebrachte Dünnfilm (16) besteht, denen des Materials, aus dem der zweitletzte vor dieser Wiederholung aufgebrachte Dünnfilm (4) besteht, gleichen.

2. Verfahren nach Anspruch 1, dadurch gekennzeichnet, dass der erste Dünnfilm (4) aus einem leitfähigen Material gemacht wird und bei den dann folgenden Dünnfilmen so verfahren wird, dass sich jeweils zwei Dünnfilme (6, 14; 26, 34) aus isolierendem Material mit zwei Dünnfilmen (16, 24) aus leitfähigem Material abwechseln.

3. Verfahren nach Anspruch 2, dadurch gekennzeichnet, dass als leitfähiges Material ein Metall und als isolierendes Material ein Glas, beispielsweise $SiO_2$ oder $Si_3N_4$, verwendet werden.

4. Verfahren nach einem der Ansprüche 1 bis 3, dadurch gekennzeichnet, dass das Ätzen unter Verwendung des darüberliegenden Dünnfilms (6, 16, 26, 36) als Maske mittels reaktiven Ionenätzens durchgeführt wird.

5. Verfahren nach einem der Ansprüche 1 bis 4, dadurch gekennzeichnet, dass , wenn ein Material aus der Gruppe Al, Al–Cu–Si-Legierungen, dotiertes Silicium, Pt, Pd, Cr und Mo geätzt wird und eine Maske aus Glas verwendet wird, als reaktives Gas $CCl_4$, HCl, $Cl_2$, HBr, $Br_2$, Trichloräthylen, $FCCl_3$, $F_2CCl_2$, FCl oder FOCl eingesetzt wird.

6. Verfahren nach einem der Ansprüche 1 bis 5, dadurch gekennzeichnet, dass jeweils der Dünnfilm (6, 16, 26, 36) auf welchem die Lackschicht (7, 18, 28, 38) aufgebracht wird, dünner als der unmittelbar darunter befindliche Dünnfilm (4, 14, 24, 34) gemacht wird.

7. Verfahren nach Anspruch 6, dadurch gekennzeichnet, dass der Dünnfilm (6, 16, 26, 36), auf welchem die Lackschicht aufgebracht wird, ungefähr 0,3 µm und der unmittelbar darunter befindliche Dünnfilm (4, 14, 24, 34) zwischen ungefähr 1 und 2 µm dick gemacht werden.

8. Verfahren nach einem der Ansprüche 1 bis 7, dadurch gekennzeichnet, dass die Lackschichten (7, 18, 28, 38) zwischen etwa 0,5 und 1,5 µm dick gemacht werden.

9. Verfahren nach einem der Ansprüche 1 bis 8, dadurch gekennzeichnet, dass auf dem Substrat (2) ganzflächig ein erster leitfähiger Dünnfilm (4), darüber ganzflächig ein erster Dünnfilm (6) aus Glas und darüber ganzflächig eine erste Schicht (7) aus einem strahlungsempfindlichen Lack aufgebracht werden, dass in der ersten Lackschicht (7) und in dem ersten Glasfilm (6) durchgehende Öffnungen (9, 10) gemäss einem gewünschten Muster erzeugt werden und daraufhin unter Verwendung des ersten Glasfilms (6) als Maske der leitfähige Film (4) selektiv mittels reaktiven Ionenätzens entfernt wird, dass anschliessend auf dem ersten Glasfilm (6) und seinen Öffnungen ganzflächig ein zweiter Glasfilm (14), darüber ganzflächig ein zweiter leitfähiger Film (16) und darüber ganzflächig eine zweite Lackschicht (18) aufgebracht werden, dass in der zweiten Lackschicht (18) und in dem zweiten leitfähigen Film (16) durchgehende Öffnungen (20, 21) gemäss einem weiteren gewünschten Muster erzeugt werden und daraufhin unter Verwendung des zweiten leitfähigen Films (16) als Maske der zweite und der erste Glasfilm (14, 6) mittels reaktiven Ionenätzens selektiv weggeätzt werden, dass daraufhin auf dem zweiten leitfähigen Film (16) und seinen Öffnungen ganzflächig ein dritter leitfähiger Film (24), darüber ganzflächig ein dritter Glasfilm (26) und darüber ganzflächig eine dritte Lackschicht (28) aufgebracht werden, dass in der dritten Lackschicht (28) und in dem dritten Glasfilm (26) durchgehende Öffnungen (30, 31) gemäss einem weiteren gewünschten Muster erzeugt werden und anschliessend unter Verwendung des dritten Glasfilms (26) als Maske der dritte und der zweite leitfähige Film (24, 16) mittels reaktiven Ionenätzens selektiv weggeätzt werden, dass schliesslich auf dem dritten Glasfilm (26) und seinen Öffnungen ganzflächig ein vierter Glasfilm (34), darüber ganzflächig ein vierter leitfähiger Film (36) und darüber eine vierte Lackschicht (38) aufgebracht werden, und dass in der vierten Lackschicht (38) und in dem vierten leitfähigen Film (36) Öffnungen (40, 41) gemäss einem weiteren gewünschten Muster erzeugt werden und anschliessend unter Verwendung des vierten leitfähigen Films (36) als Maske der vierte und der dritte Glasfilm (34, 26) mittels reaktiven Ionenätzens selektiv weggeätzt werden.

10. Verfahren nach einem der Ansprüche 1 bis 9, gekennzeichnet durch seine Verwendung bei der Herstellung von Metallisierungsstrukturen, welche Leiterzugmuster in mindestens zwei Ebenen aufweisen, welche übereinanderliegen und leitend miteinander verbunden sind und im übrigen durch ein Isoliermaterial voneinander getrennt sind und gegebenenfalls einer Passivierungsschicht vor äusseren Einflüssen geschützt sind.

**Claims**

1. Method of making a thin film structure, where on a substrate (2) a first thin film (4) of a first material is blanket-deposited, and thereupon a second thin film (6) of a second material is blanket-deposited, the etching properties of the first material differing from those of the second material, and where a layer (7) of a radiationsensitive resist is blanket-deposited, where in the resist layer (7) and in the second thin film (6), openings (9, 10) are made in accordance with a predetermined pattern, and where subsequently etching takes place using the second thin film (6) as a mask and with conditions at which the first material is removed, characterized in that subsequently on each last thin film applied and on its openings the above mentioned process steps are repeated at least once starting with the application of a thin film up to the etching process using the thin film over it as a mask, the material used being such that the etching characteristics of the material of the first thin film (14) applied in a repetition are the same as those of the material of the last thin film (6) applied prior to this repetition, and the etching characteristics of the material of the second thin film (16) applied in a repetition are the same as the material of the second but one thin film (4) applied prior to this repetition.

2. Method as claimed in claim 1, characterized in that the first thin film (4) is made of a conductive material, and that with respect to the subsequent thin film processes, two thin films (6, 14; 26, 34) of an insulating material always alternate with two thin films (16, 24) of conductive material.

3. Method as claimed in claim 2, characterized in that for a conductive material a metal and for an insulating material a glass, e.g. $SiO_2$ or $Si_3N_4$, are used.

4. Method as claimed in any one of claims 1 to 3, characterized in that the etching is effected by means of reactive ion etching, using the superimposed thin film (6, 16, 26, 36) as a mask.

5. Method als claimed in any one of claims 1 to 4, characterized in that when a material of the group consisting of Al, Al–Cu–Si alloys, doped silicon, Pt, Pd, Cr and Mo is etched, and a glass mask is used, $CCl_4$, HCl, $Cl_2$, HBr, $Br_2$, trichloroethylene, $FCCl_3$, $F_2CCl_2$, FCl or FOCl is used as reactive gas.

6. Method as claimed in any one of claims 1 to 5, characterized in that the respective thin film (6, 16, 26, 36) onto which the resist layer (7, 18, 28, 38) is applied is thinner than the thin film (4, 14, 24, 34) provided immediately beneath it.

7. Method as claimed in claim 6, characterized in that the thin film (6, 16, 26, 36) onto which the resist layer is applied is approximately 0.3 $\mu$m thick and the thin film (4, 14, 24, 34) provided immediately beneath it is between approximately 1 and approximately 2 $\mu$m thick.

8. Method as claimed in any one of claims 1 to 7, characterized in that the resist layers (7, 18, 28, 38) are between approximately 0.5 and approximately 1.5$\mu$m thick.

9. Method as claimed in any one of claims 1 to 8, characterized in that onto the substrate (2) a first conductive thin film (4) is blanket-deposited, atop that a first thin film (6) of glass is blanket-deposited, and atop that a first layer (7) of a radiation-sensitive resist is blanket-deposited, that in the first resist layer (7) and in the first glass film (6), openings (9, 10) in accordance with a predetermined pattern are made, and subsequently using the first glass film (6) as a mask the conductive film (4) is selectively removed by means of reactive ion etching, that subsequently on the first glass film (6) and its openings a second glass film (14) is blanket-deposited, atop that a second conductive film (16) is blanket-deposited, and atop that a second resist layer (18) is blanket-deposited, that in the second resist layer (18) and in the second conductive film (16), openings (20, 21) according to another predetermined pattern are made, and that subsequently using the second conductive film (16) as a mask the second and the first glass films (14, 6) are selectively etched off by means of reactive ion etching, that subsequently on the second conductive film (16) and its openings a third conductive film (24) is blanket-deposited, atop that a third glass film (26) is blanket-deposited, and atop that a third resist layer (28) is blanket-deposited, that in the third resist layer (28) and in the third glass film (26), openings (30, 31) according to still another predetermined pattern are made, and that subsequently using the third glass film (26) as a mask the third and the second conductive film (24, 16) are selectively etched off by means of reactive ion etching, that subsequently on the third glass film (26) and its openings a fourth glass film (34) is blanket-deposited, that atop that a fourth conductive film (36) is blanket-deposited, and atop that a fourth resist layer (38) is applied, and that in the fourth resist layer (38) and in the fourth conductive film (36) openings (40, 41) according to still another predetermined pattern are made, and that subsequently using the fourth conductive film (36) as a mask the fourth and the third glass film (34, 26) are selectively etched off by means of reactive ion etching.

10. Method as claimed in any one of claims 1 to 9, characterized by its use in the production of metallization structures having conductive line patterns in at least two planes which are provided one over the other and which are conductively interconnected, and which furthermore are separated from each other by an insulating material, and which if necessary are protected by a passivation layer against external influences.

**Revendications**

1. Procédé pour fabriquer une structure de film mince, dans lequel on dépose sur toute la surface d'un substrat (2) un premier film mince (4) d'un premier matériau, et sur toute la surface de ce film un second film mince (6) d'un second matériau, les propriétés de décapage du premier matériau étant différentes de celles du second matériau, et on dépose sur toute la surface de ce film une couche (7) d'un vernis sensible à la radiation, dans lequel on forme dans la couche de vernis (7) et dans le second film mince (6) des ouvertures de traversée (9, 10) selon une configuration désirée et on décape ensuite en utilisant le second film mince (6) comme masque et dans des conditions qui enlèvent le premier matériau, ledit procédé étant caractérisé en ce qu'on répète ensuite, au moins une fois, sur la couche mince déposée en dernier et dans ses ouvertures les étapes de procédé mentionnée ci-dessus allant du dépôt d'un film mince au décapage en utilisant le film mince superposé comme masque, les matériaux utilisés étant tels que les propriétés de décapage du matériau du premier film mince (14) déposé pendant un processus de répétition sont similaires à celles du matériau du dernier film mince (6) déposé avant ce processus de répétition, et les propriétés de décapage du matériau du second film mince (16) déposé dans un processus de répétition étant similaires à celles du matériau de l'avant dernier film mince (4) déposé avant ce processus de répétition.

2. Procédé selon la revendication 1, caractérisé en ce que le premier film mince (4) est constitué par un matériau conducteur et que les films minces suivants sont arrangés de telle sorte que deux films minces (6, 14; 36, 34) d'un matériau isolant alternent avec deux films minces (16, 24) d'un matériau conducteur.

3. Procédé selon la revendication 2, caractérisé en ce qu'on utilise comme matériau conducteur un métal et comme matériau isolant un verre, par exemple le $SiO_2$ ou le $Si_3N_4$.

4. Procédé selon l'une quelconque des revendications 1 à 3, caractérisé en ce que le décapage est un décapage par ions réactifs utilisant le film mince superposé (6, 16, 26, 36) comme masque.

5. Procédé selon l'une quelconque des revendications 1 à 4, caractérisé en ce qu'on utilise comme gaz réactif le $CCl_4$, le $HCl$, le $Cl_2$, le $HBr$, le $Br_2$, le trichloroéthylène, le $FCCl_3$, le $F_2CCl_2$, le $FCl$, ou le $FOCl$ lorsqu'on décape un matériau du groupe comprenant du Al, des alliages Al–Cu–Si, du silicium dopé, du Pt, du Pd, du Cr et du Mo et lorsqu'on utilise un masque en verre.

6. Procédé selon l'une des revendications 1 à 5, caractérisé en ce que le film mince (6, 16, 26, 36) sur lequel on dépose la couche de vernis (7, 18, 28, 38) est plus mince que le film mince (4, 14, 24, 34) qui est immédiatement sous-jacent.

7. Procédé selon la revendication 6, caractérisé en ce que le film mince (6, 16, 26, 36) sur lequel est déposée la couche de vernis a une épaisseur d'environ 0,3 µm et le film mince (4, 14, 24, 34) immédiatement sous-jacent a une épaisseur comprise entre environ 1 et 2 µm.

8. Procédé selon l'une des revendications 1 à 7, caractérisé en ce que les couches de vernis (7, 18, 28, 38) ont une épaisseur comprise entre environ 0,5 et 1,5 µm.

9. Procédé selon l'une quelconque des revendications 1 à 8, caractérisé en ce qu'on dépose sur toute la surface du substrat (2), un premier film mince conducteur (4), sur toute la surface de ce film un premier film mince (6) en verre, et sur toute la surface de ce film une première couche (7) d'un vernis sensible à la radiation; on forme dans la première couche de vernis (7) et dans le premier film de verre (6) des ouvertures de traversée (9, 10) selon une configuration désirée et on enlève ensuite le film conducteur (4) sélectivement à l'aide du décapage par ions réactifs en utilisant le premier film de verre (6) comme masque; on dépose ensuite sur toute la surface du premier film de verre (6) et ses ouvertures un second film de verre (14) et sur toute la surface de ce film un second film conducteur (16) et sur toute la surface de ce film une seconde couche de vernis (18); on forme dans la seconde couche de vernis (18) et dans le second film conducteur (16) des ouvertures (20, 21) selon une autre configuration désirée et on enlève ensuite les second et premier films de verre (14, 6) à l'aide du décapage par ions réactifs en utilisant le second film conducteur (16) comme masque; on dépose ensuite sur toute la surface du second film conducteur (16) et ses ouvertures un troisième film conducteur (24), et sur toute la surface de ce film un troisième film de verre (26) et sur toute la surface de ce film une troisième couche de vernis (28); on forme dans la troisième couche de vernis (28) et dans le troisième film de verre (26) des ouvertures de traversée (30, 31) selon une autre configuration désirée et on enlève ensuite à l'aide du décapage par ions réactifs le troisième et second films conducteurs (24, 16) en utilisant le troisième film de verre (26) comme masque; on dépose ensuite sur toute la surface du troisième film de verre (26) et ses ouvertures un quatrième film de verre (34), sur toute la surface de ce film un quatrième film conducteur (36) et sur ce film une quatrième couche de vernis (38); on forme enfin dans la quatrième couche de vernis (38) et dans le quatrième film conducteur (36) des ouvertures (40, 41) selon une autre configuration désirée et on décape ensuite sélectivement à l'aide du décapage par ions réactifs les quatrième et troisième films de verre (34, 26) en utilisant le quatrième film conducteur (36) comme masque.

10. Procédé selon l'une quelconque des revendications 1 à 9, caractérisé par son application dans la fabrication de structures métallisées comportant des configurations de conducteur dans au moins deux plans superposés et interconnectés de manière à être conducteurs et qui sont en outre séparés par un matériau isolant et éventuellement protégés contre des influences extérieurs par une couche de passivation.

0 008 359

METALLISCHEN FILM 4 AUFBRINGEN

GLASFILM 6 AUFBRINGEN

**FIG. 1A**

LACKSCHICHT 7 AUFBRINGEN

**FIG. 1B**

BESTRAHLEN UND ENTWICKELN DER LACKSCHICHT 7

ÜBERTRAGUNG DES MUSTERS IN DEN GLASFILM 6

**FIG. 1C**

ÄTZEN DES FILM 4 MIT GLASFILM 6 ALS MASKE

**FIG. 1D**

GLASFILM 14 AUFBRINGEN

**FIG. 1E**

11

| METALLISCHEN FILM 16 AUFBRING. |
| --- |

| LACKSCHICHT 18 AUFBRINGEN |

**FIG. 1F**

| BESTRAHLEN UND ENTWICKELN DER LACKSCHICHT 18 |
| --- |

| ÜBERTRAGEN DES MUSTERS IN DEN METALLISCHEN FILM 16 |

**FIG. 1G**

| ÄTZEN DER GLASFILME 14 UND 6 MIT DEM FILM 16 ALS MASKE |
| --- |

**FIG. 1H**

| METALLISCHEN FILM 24 AUFBRING |
| --- |

**FIG. 1I**

```
┌─────────────────────────────┐
│  GLASFILM 26 AUFBRINGEN      │
└─────────────────────────────┘

┌─────────────────────────────┐
│  LACKSCHICHT 28 AUFBRINGEN   │
└─────────────────────────────┘
```

28
26
24
16
14
6
4
2

## FIG. 1J

```
┌─────────────────────────────┐
│  BESTRAHLEN UND ENTWICKELN   │
│  DER LACKSCHICHT 28          │
└─────────────────────────────┘

┌─────────────────────────────┐
│  ÜBERTRAGEN DES MUSTERS IN   │
│  DEN GLASFILM 26             │
└─────────────────────────────┘
```

30   31

28
26
24
16
14
6
4
2

## FIG. 1K

```
┌─────────────────────────────┐
│  ÄTZEN DER FILME 24 UND 16   │
│  MIT GLASFILM 26 ALS MASKE   │
└─────────────────────────────┘
```

30'   31'

26
24
16
14
6
4
2,

## FIG. 1L

15

FIG. 2

FIG. 3